# DEMANDE DE BREVET EUROPEEN

(11) **EP 4 518 143 A1**
(43) Date de publication de la demande: **05.03.2025**
(21) Numéro de dépôt: 24197443.5
(22) Date de dépôt: 30.08.2024
(51) Int. Cl.: H02S 10/10, H02S 40/44, H10F 19/80, H10N 10/00, H02S 99/00

(54) **PROCÉDÉ DE FABRICATION D'UN DISPOSITIF ÉNERGÉTIQUE PAR COUCHE THERMOÉLECTRIQUE ET/OU THERMOPHOTOVOLTAÏQUE ET GEL PHOTOVOLTAÏQUE DÉDIÉ POUR VÉHICULES, BÂTIMENTS ET OBJETS CONNECTÉS**

(30) Priorité: 31.08.2023 CH 9252023
(71) Demandeur: Halimi, Eric, 69100 Villeurbanne Rhône (FR)
(72) Inventeur: HALIMI, ERIC, 69100 VILLEURBANNE (FR); HALIMI, ERIC, 69100 VILLEURBANNE (FR)

(57) **Abrégé**

L'invention comporte une couche transparente de cellules thermoélectriques et/ou thermophotovoltaïques (Fig 1.2 , 1.1) et un dispositif de cellules photovoltaïques sous forme filaire, invisible à l'oeil nu (Fig 1.3) situés entre deux couches ou intégrés dans tous matériaux (Fig 1.5) et fonctionnant dans un gel transparent hydroélectrique diélectrique anti-reflet présentant de grande capacité de collage et de solidification à l'air (Fig 1.4). Le système photovoltaïque utilisé peut se présenter en un fil conducteur de faible épaisseur, contenant les cellules photovoltaïques alignées et séparées entre elles par des zones de transparence. Le dispositif énergétique permet un apport d'énergie tel l'électricité produite par l'ensemble du fait de la lumière (photons) et de la chaleur, récupérée par le dispositif comportant au moins une électrode fichée dans le gel diélectrique, et ré-injectée dans une batterie rechargeable ou tout autre appareil électrique. Le dispositif peut être complété par la pose d'un film pouvant s'opacifier instantanément, soit selon un critère fixé d'avance ou manuellement (Fig 1.6).

## Description

### Domaine technique:

L'invention intervient dans différents domaines tels l'immobilier, le BIPV (Building Integrated PhotoVoltaics) pour les bâtiments et habitations, l'aviation, l'automobile pour les véhicules terrestres, les objets mobiles connectés ... usant d'au moins une batterie rechargeable.

Elle a pour but écologique d'améliorer leur performance énergétique telles les surfaces vitrées des habitations, des bâtiments et structures industriels ou commerciales ou bien d'abaisser le coût du système proposé pour les véhicules électriques ou hybrides soit en usant de batterie de moindre performance, soit en permettant une économie du coût du trajet, en diminuant l'usage du moteur essence et ainsi de réduire les niveaux d'émission de CO2.

### Etat de la technique :

Le soleil émet de l'énergie sous la forme d'un rayonnement électromagnétique, dont les longueurs d'onde sont comprises essentiellement entre 0,2 et 3 microns.

Le rendement des cellules photovoltaïques est le rapport entre la quantité d'énergie captée et la quantité d'électricité produite.

Par exemple, pour une cellule qui aurait un rendement de 20%, cela signifie que :
- 20 % de l'énergie solaire est transformée en électricité,
- 80 % de l'énergie est perdue sous forme de chaleur.

Plus le taux de rendement est élevé et plus la cellule produit de l'électricité. Mais en tout état de cause, l'énergie dissipée sous forme de chaleur représente des pertes essentielles.

D'autres facteurs peuvent avoir un impact sur le rendement des modules solaires, tels leur orientation et leur inclinaison, ce qui joue un rôle pour la production de l'électricité.

Les cellules photovoltaïques actuellement utilisées présentent un rendement élevé dans le spectre compris entre 0,6 et 1,2 micron, avec un maximum dans la région de 0,85 micron, en dehors de cette plage, ces cellules deviennent chaudes et perdent rapidement leur efficacité.

Dans le cas du fonctionnement réel des modules photovoltaïques usuels, la température de surface des modules atteint généralement plus de 70°C. Travailler à haute température pendant une longue période est très préjudiciable à l'efficacité, à la stabilité et à la durée de vie des cellules photovoltaïques. Ces pertes intrinsèques peuvent représenter jusqu'à 50% de l'énergie solaire incidente, qui est alors dissipée sous forme de chaleur dans la cellule. Si cette partie de la chaleur peut être récupérée, l'efficacité globale de conversion d'énergie du module photovoltaïque peut être encore améliorée et la température de fonctionnement de la cellule photovoltaïque peut être réduite dans une certaine mesure (l'énergie thermique est convertie en énergie électrique), et la durée de vie du module photovoltaïque peut être prolongée.

Les cellules thermoélectriques ont une énergie propre sans décharge de substance dangereuse, ayant une grande fiabilité et une longue durée d'utilisation, et fournissant une électricité stable, sûre et continue. Le rendement de la ou de chaque cellule thermoélectrique dépend essentiellement de la différence de température entre un côté chaud et un côté froid, mais beaucoup moins de la température du rayonnement incident La présence supplémentaire d'au moins une cellule thermoélectrique augmente le rendement global d'un dispositif énergétique solaire, puisque elle absorbera l'énergie incidente perdue et la chaleur dissipée par les cellules photovoltaïques, ce qui permettra d'augmenter la durée de vie de ces dernières.

En ajoutant des cellules thermoélectriques, on récupère ainsi une partie de cette chaleur en la convertissant en électricité, ce qui contribue à réduire la température des cellules photovoltaïques tout en améliorant le rendement global du dispositif solaire et en prolongeant sa durée de vie.

Dans le contexte actuel de réchauffement climatique intense et non maîtrisé, la conversion de la chaleur résiduelle inutilisée en électricité pour réduire la charge environnementale est un enjeu important. Les cellules thermoélectriques de dernières générations ont également la faculté de transformer une partie de l'énergie calorifique contenue dans l'air, la chaleur ambiante qui ne fait qu'augmenter, en électricité.

Les cellules thermophotovoltaïques (TPV), elles, sont des cellules photovoltaïques qui sont optimisées pour convertir le rayonnement électromagnétique proche infrarouge et infrarouge en électricité (les cellules photovoltaïques usuelles fonctionnent principalement dans le visible). Cette technologie permet ainsi d'élargir la gamme des longueurs d'onde pouvant être converties en électricité. En théorie, l'efficacité d'une cellule TPV peut dépasser les 50%, mais en pratique, les scientifiques n'ont jusqu'à présent jamais dépassé les 35%.

Les TPV ne sont pas affectées par le jour et la nuit, les saisons ou les conditions météorologiques car elles peuvent utiliser des sources de chaleur. Elles sont de structure simples, moins sujettes aux pannes avec une efficacité plus élevée. La puissance obtenue par unité de surface est plus grande, le rendement plus élevé et les performances sont stables. Et surtout, les TPV sont aptes à transformer le rayonnement solaire proche infrarouge et infrarouge en électricité, ce qui est peu exploité avec les cellules photovoltaïques actuelles standards.

Les cellules TPV convertissent les rayons proches infrarouges et infrarouges en électricité, ces derniers représentent les ondes lumineuses les plus chaudes d'un point de vue thermique et les plus abondantes du spectre solaire (plus de 50% des ondes émises par le soleil).

L'ajout de cellules TPV dans un dispositif photovoltaïque permet de diminuer la température et d'augmenter le rendement énergétique global du système solaire.

Ainsi, les cellules TPV convertissent non seulement la lumière proche infrarouge et infrarouge abondante du soleil mais aussi la chaleur excédentaire générée par les cellules photovoltaïque en électricité. Cela contribue à réduire la surchauffe des cellules photovoltaïques, augmente la durée de vie de ces dernières, améliore le rendement global du dispositif solaire en augmentant la production d'électricité.'

L'invention connue FR°1701099 présente un dispositif énergétique de type gel photovoltaïque. Celui-ci mis à l'épreuve en situation réelle, pour les raisons évoquées ci-dessus notamment en terme de déperdition d'énergie, n'est pas optimum en rendement et limite la durée de vie des cellules photovoltaïques, ce qui constitue un inconvénient.

### Exposé de l'invention :

Afin de récupérer et valoriser toutes les énergies évoquées ci-dessus, il est donc intéressant de proposer un dispositif énergétique combiné, optimum en conversion photovoltaïque et thermoélectrique et limitant les déperditions d'énergie tout en augmentant la durée de vie des cellules photovoltaïques, ce qui permettra de pallier aux inconvénients cités ci-dessus .

L'invention concerne plus précisément un dispositif comprenant des cellules thermoélectriques et/ou thermophotovoltaïques (TPV) ainsi que des cellules photovoltaïques intégrées dans le support (vitrages, Plexiglas (marque déposée), miroirs, dispositifs ou matériaux transparents ou semi-transparents ou réfléchissants ou semi-conducteurs ou conducteurs ...

Les cellules photovoltaïques seront environnées par un gel hydroélectrique, transparent, non-visqueux présentant des qualités diélectriques, de grandes capacités de collage (type cyanolate) et de solidification à l'air.

Ce gel présentera en conséquence l'avantage d'assurer une plus grande résistance des matériaux utilisés pour les pare-brises, vitrages, miroirs tels ceux des rétroviseurs...

Les diélectriques, transparents dans de larges gammes de fréquences, permettront également de constituer une couche anti-reflet du gel. Cette couche réduira la réflexion de la lumière solaire incidente, ce qui permettra une meilleure absorption par les couches de matériau semiconducteur sous-jacentes optimisant le rendement de conversion de la lumière en électricité.

Les cellules thermoélectriques et/ou TPV seront directement intégrées dans ledit gel hydroélectrique transparent par exemple sous forme filaire ou bien être disposées sur un film souple transparent, lui même positionné en surface du gel de sorte ces cellules soient en contact direct avec le gel.

Le dispositif global permet de récupérer de l'énergie et de la chaleur pour qu'elles puissent être redirigées sous forme d'électricité sur un accumulateur de type batterie ou sur un appareil ou dispositif électrique ou bien directement sur une résistance dans le cadre d'un dispositif calorifique.

Ce dispositif global peut être également complété par la pose d'un film opacifiant autonome qui permettra d'assombrir à volonté le vitrage, le Plexiglas° (marque déposée), le miroir afin de réduire l'éblouissement et la chaleur entrant dans une habitation ou l'habitacle d'un véhicule. Tout comme les verres à contrôle solaire, le dispositif maintiendra au mieux la température et évitera ainsi l'utilisation de la climatisation. De surcroît, lorsque l'on quitte son habitation ou que le véhicule est à l'arrêt, le vitrage s'obscurcit permettant aussi d'améliorer la sécurité en dissimulant l'intérieur aux regards extérieurs. Ce film est principalement constitué de cristaux liquides, il a une faible consommation énergétique, est fiable dans le temps et ne nécessite aucun entretien spécifique.

Le dispositif proposé répond aux besoins énergétiques croissants en réduisant la dépendance énergétique aux énergies fossiles des véhicules, des habitations, des bâtiments et structures industriels ou commerciales .... En outre, il améliore l'autonomie des véhicules électriques et hybrides et limite l'utilisation des batteries, qui doivent sans cesse être rechargée par le réseau électrique. Ce dernier utilisant pour son fonctionnement principalement tous matériaux fossiles et a souvent recours à l'énergie nucléaire.

Ainsi l'un des avantages du dispositif énergétique est sa capacité à produire de l'électricité sans émission directe de gaz à effet de serre (GES) dans les secteurs d'activité énergivores (tertiaire, mobilité embarqué ...), contribuant ainsi à lutter contre le changement climatique et ses impacts néfastes sur la biodiversité.

En remplaçant en partie les sources d'énergie fossile, le dispositif énergétique peut limiter la pression sur les écosystèmes qui sont affectés par l'extraction de combustibles fossiles ou par la construction de barrages hydroélectriques.

Le dispositif produit de l'électricité sans émission directe de CO2 et de bruit, cette énergie propre et silencieuse contribue à créer un environnement plus sain et plus agréable pour les communautés avoisinantes. La réduction de la pollution atmosphérique (tels que les particules fines, les oxydes d'azote et les composés organiques volatils) améliore nettement la qualité de l'air et réduit ainsi les problèmes de santé humaine associés à la pollution atmosphérique, comme les maladies respiratoires et cardiovasculaires.

En intégrant le dispositif par exemple sur des surfaces de bâtiments (BIPV) et habitations ou fermes agricoles, on permet un apport ou un accès à de l'électricité à des populations vivant dans des zones éloignées ou mal desservies. Cela peut améliorer les conditions de vie et favoriser le développement socio-économique.

Grâce à une énergie verte renouvelable, inépuisable : le soleil, le dispositif combiné s'inscrit pour le développement durable dans l'objectif 0 émission de CO2. Il utilise peu de ressources naturelles à l'instar des panneaux photovoltaïques standards (nécessitant du sable pour la fabrication des verres, de l'aluminium, des métaux... ), des stores ou des tuiles solaires.

Un objet de la présente invention est donc de permettre la moindre dépendance énergétique des habitations et bâtiments, des véhicules électriques et hybrides, des objets mobiles connectés tout en améliorant leur autonomie, de résoudre des problèmes liés à l'IoT... Sans compter que la présente invention peut permettre de générer des économies substantielles sur la part du budget des dépenses énergétiques des entreprises et ménages, et avoir un impact positif sur leur pouvoir d'achat.

Un autre objet de la présente invention est de créer des générateurs d'électricité sur des surfaces peu (ou pas) exploitées à ce jour tels les écrans de smartphones et de tablettes connectées, les vitrages des véhicules (mobilité embarquée) et ce sans en altérer l'apparence, ouvrant ainsi la voie à une esthétique plus attrayante et innovante.

Un autre objet de la présente invention est de proposer un dispositif énergétique qui se caractérise par des coûts d'installation et de fonctionnement relativement faibles, un procédé de fabrication faible énergétiquement et une emprunte carbone faible compensée par un rapide remboursement de «la dette énergétique » (l'amortissement rapide de la fabrication et la durée de vie du dispositif compensent rapidement les émissions de CO2 nécessaires à sa fabrication).

Un autre objet de la présente invention est de fournir un dispositif énergétique polyvalent, qui est approprié pour une utilisation fréquente tout en assurant une longue durée de vie.

Un autre objet de la présente invention est de proposer un système de récupération de la chaleur qui permet le dégivrage ou le chauffage de tous types de vitrages aussi bien pour les véhicules disposant d'au moins une batterie électrique rechargeable que les vitrages des habitations, des bâtiments ou structures industriels ou commerciales ...

Un autre objet de la présente invention est de proposer un dispositif photovoltaïque qui fonctionne tant à la lumière naturelle qu'artificielle, qui soit adapté à la fois à la lumière de faible intensité avec un angle d'incidence élevé qu'au spectre d'émission des lampes fluorescentes et LED et qui absorbe le spectre solaire même dans les zones ombragées

Un autre objet de la présente invention est de proposer un dispositif énergétique de faible épaisseur et de poids léger qui n'alourdie que faiblement les surfaces où il est intégré (contrairement aux panneaux PV standards) et qui s'intègre parfaitement dans de nombreuse surfaces tels celles :
- des objets mobiles connectés de types mobiles, smartphones, tablettes, drones
- des lunettes photo-chromatiques ou connectées
- des objets connectés sans pour autant être forcement mobiles tels les téléviseurs, les imprimantes, les écrans d'affichage, les panneaux publicitaires etc ...

Un autre objet de la présente invention est de palier aux problèmes de recyclage des solutions standards photovoltaïques existantes notamment celles des panneaux PV en proposant un dispositif photovoltaïque intégrable à de nombreuses surfaces et constitué principalement d'eau (hydro gel). Quant au film SPB opacifiant, le système de recyclage des cristaux liquides, d'après les études portées, comprend 6 étapes: la séparation, l'extraction, la purification, le lavage, la concentration et la modification, permettant ainsi la réutilisation des cristaux liquides et des verres usagés. Ce système de recyclage permet non seulement d'extraire les cristaux liquides usagés à un taux de récupération proche de 100%, mais le verre recyclé peut également être utilisé comme matériel de construction isolant thermique, ou comme absorbant de métaux lourds dans le traitement des eaux usées.

### Liste des dessins :

Des exemples de mise en oeuvre de l'invention sont indiqués dans la description illustrée par les figures annexées dans lesquelles:
- La figure1 représente le dispositif énergétique de l'invention avec ses différentes couches (vu de face ou d'hauteur)
- La figure 2 représente le dispositif énergétique de l'invention avec ses différentes couches (vu de coupe)
- La figure 3 illustre l'intégration du dispositif énergétique de l'invention dans un véhicule électrique ou hybride

### Réalisation de l'invention :

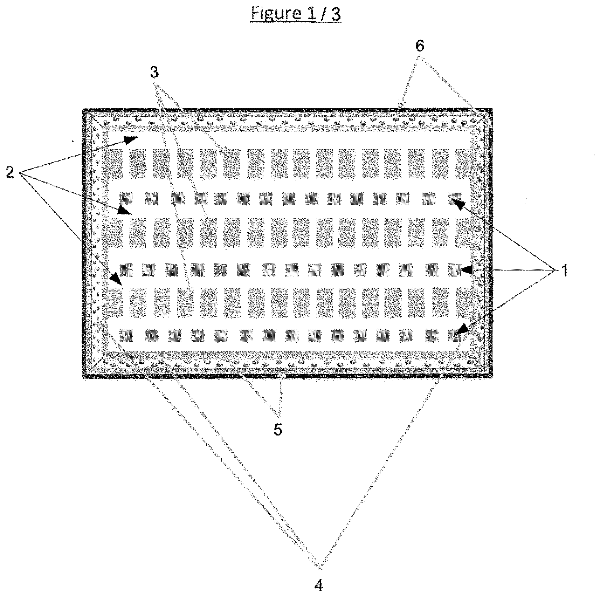

L'invention comporte une couche transparente de cellules thermoélectriques et/ou thermophotovoltaïques (Fig 1.2) et sous forme filaire un dispositif de cellules photovoltaïques, invisibles à l'oeil nu (Fig 1.3) injectés ou situés entre deux couches de matériaux transparents ou semi-transparents ou réfléchissants (Fig_1.5) ou conducteurs ou semi-conducteurs et fonctionnant dans un gel transparent hydroélectrique et diélectrique présentant de grande capacité de collage et de solidification à l'air (Fig 1.4).

Pour parfaire l'efficience du dispositif photovoltaïque et augmenter sa durée de vie, les cellules thermoélectriques ou thermophotovoltaïques ou une combinaison des deux (Fig 1.1) sont intégrées dans ledit gel par exemple sous forme filaire ou idéalement positionnées sur un film souple transparent à la lumière, lui-même posé en surface du gel de sorte que ces cellules thermoélectriques et/ou TPV sont en contact avec ledit gel.

Ce gel ou plus précisément le dispositif énergétique combiné sera injecté dans les matériaux ou entre deux couches de matériaux.

L'électricité produite par l'ensemble du fait de la chaleur et de la lumière (photons) sera récupérée par un dispositif comportant au moins une électrode fichée dans le gel diélectrique, et ré-injectée dans une batterie rechargeable. Le cas échéant, cette énergie supplémentaire pourra être directement dirigée vers tout appareil ou dispositif électrique afin de suppléer la batterie ou bien directement sur une résistance dans le cadre d'un dispositif calorifique.

Le dispositif pourra être complété par la pose d'un film opacifiant autonome (Fig 1.6).

### Le système photovoltaïque (Fig 1.3)

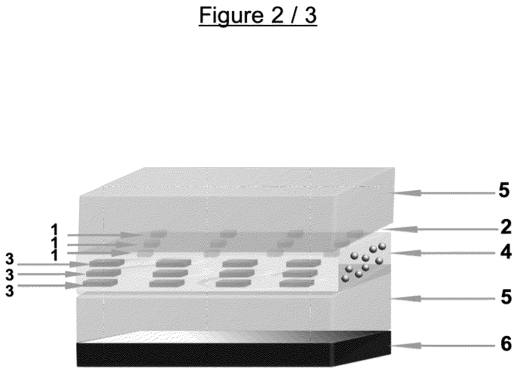

Il s'agira de poser ce système à l'intérieur des surfaces vitrées, Plexiglas (marque déposée), miroirs ... (cf Fig 2. 7 8 9) afin d'obtenir un apport d'énergie.

Les cellules photovoltaïques seront microscopiques ou formées d'un empilement de couches minces ou semi-transparentes à la lumière et pourront être des cellules de type pérovskite, Tandem (silicium, pérovskite), III-V, organique (OPV) ou tous autres types, de préférence souples et de tous types de formes. Elles seront séparées par des zones de transparence et alignées entre elles de sorte que les dites cellules photovoltaïques ne seront pas visibles individuellement à l'oeil nu.

Les dites cellules seront disposées sur un substrat filaire transparent à la lumière.

Le système photovoltaïque utilisé pourra ainsi se présenter en un fil de faible épaisseur de moins de 150 microns.

Le fil supportant les cellules photovoltaïques sera un fil conducteur capable de transporter des charges électriques (positives tels les trous, négatives tels les électrons), des charges ioniques...

Le fil sera transparent (quasi-imperceptible à l'oeil nu) et ayant l'avantage d'accroître la tension électrique aux bornes du module et de réduire le courant conduit par les électrodes du module; ce qui permettra de réduire les pertes dues à la résistance des matériaux, notamment au niveau de l'électrode.

En outre cela évitera une électro-luminescence du gel hydroélectrique entourant le module photovoltaïque.

Dans un mode de réalisation, les cellules photovoltaïques seront interconnectées entre elles par un fil conducteur transparent disposé systématiquement entre deux cellules successives laissant une zone de transparence entre chaque cellule de sorte que le dispositif photovoltaïque soit sous forme filaire dans le gel

L'électrode transparente pourra être constituée de graphème ou de mono-structures métalliques ou non ou d'un oxyde transparent de type SnO2, **ITO,** IZO, AZO L'électrode métallique pourra être formée d'un métal tel l'or, le chrome, le titane, l'aluminium ...

### Le gel hydroélectrique (Fig 1.4)

Celui-ci sera posé ou injecté dans tout élément ou matériaux, tels que vitrages, miroirs, Plexiglas (marque déposée), plastiques, composites, résines, transparents ou semi-transparents ou conducteurs ou semi-conducteurs ... afin d'assurer le transport de l'énergie produite par le système photovoltaïque.

Ce gel présentera les propriétés suivantes:
- diélectrique et anti-reflet,
- thermocollage avec solidification à l'air,
- transparence et absence de viscosité.

Dans un mode de réalisation, le gel pourra agir comme un électrolyte ou contenir des électrolytes, ce qui facilitera la conduction des charges électriques ou ioniques entre les électrodes et améliorera l'efficacité de conversion de la lumière en électricité dans les cellules photovoltaïques Des électrolytes ioniques présentent une stabilité élevée, ce qui peut contribuer à une plus grande durée de vie des cellules photovoltaïques et à une meilleure performance à long terme. Ils pourront être choisis pour être transparents dans le spectre visible de la lumière, permettant ainsi de conserver la transparence globale du gel et du système photovoltaïque.

Ce gel hydroélectrique pourra être posé dans un film souple transparent pouvant être posé ou collé ou intégré sur tous matériaux notamment non-conducteurs ou non-transparents ((tels que carrosseries, capotes, coques de rétroviseurs, ailerons, spoiler, surfaces métalliques (telles tôles), matériaux inertes (tels murs, sols, toits) ...) afin de permettre l'alimentation électrique directe de l'élément ou matériel ou de compléter l'alimentation d'une batterie rechargeable.

### Les cellules thermoélectriques et thermophotovoltaïques TPV (Fig 1.1)

Les cellules thermoélectriques et/ou TPV seront disposées dans ledit gel par exemple sous forme filaire ou idéalement positionnées sur un film souple transparent à la lumière qui sera lui-même posé en surface dudit gel de sorte que ces dites cellules soient en contact avec ledit gel; elles formeront une couche transparente thermoélectrique et/ou TPV (Fig1.2).

Le dispositif global supporté par ledit film souple transparent pourra être posé, collé, inséré ou fixé sur tous matériaux notamment une surface vitrée, un rétroviseur ou un miroir, un Plexiglas° ou un plastique ou un élément composite, ou des matériaux non-conducteurs ou non-transparents ... afin de permettre l'alimentation électrique directe de l'élément ou matériel ou de compléter l'alimentation d'une batterie rechargeable ou bien directement alimenter une résistance dans le cadre d'un dispositif calorifique.

Dans un mode de réalisation, les cellules thermoélectriques et/ou TPV seront semi-transparentes et/ou séparées entre elles par des zones de transparence de sorte que les dites cellules ne seront pas visibles individuellement à l'oeil nu. Elles pourront se présenter sous la forme de bandes et être parallèles entre elles.

Les dites cellules thermoélectriques et/ou TPV filtreront elles-mêmes les longueurs d'onde requises, de sorte que le rayonnement qui n'est pas absorbé passe à travers les cellules vers un autre émetteur.

Les dites cellules thermoélectriques et/ou TPV pourront être positionnées de sorte qu'elles ne diminuent pas davantage le passage de la lumière au travers des cellules photovoltaïque présentes dans ledit gel hydroélectrique transparent.

La face chaude et la face froide des cellules thermoélectriques pourront être en contact respectivement avec un radiateur semi-transparent chaud et un radiateur semi-transparent froid composés chacun de bandes thermiques qui pourront être parallèles et espacées par des bandes de transparence, les dites bandes thermiques ayant des largeurs et des épaisseurs inférieures à 5 microns, de sorte que les radiateurs polariseront d'une manière rectiligne une partie du spectre de la lumière qui les traverse et que la lumière polarisée qui a traversé un des radiateurs traverse ensuite l'autre radiateur produit sans perte d'intensité.

Les dites cellules thermoélectriques pourront être traversées par le courant généré par les cellules photovoltaïques dudit gel et/ou les cellulesTPV ou bien encore par un courant électrique généré par une source de courant extérieure. Et ce, de manière à créer premièrement l'échauffement et le refroidissement respectivement de la face chaude et de la face froide desdites cellules thermoélectriques et deuxièmement d'échauffer et de refroidir les radiateurs correspondants de manière à échauffer et/ou refroidir chacune des faces de ladite surface thermoélectrique. Une application de ce mode de réalisation sera le dégivrage des vitres, miroirs et des rétroviseurs d'un véhicule.

### Le film opacifiant autonome (Fig 1.6)

Le fonctionnement du dispositif énergétique pourra être complété par la pose d'un film pouvant s'opacifier instantanément, soit selon un critère fixé d'avance (tel le niveau d'éblouissement) ou manuellement (Fig 1.6). Le film sera fixé sur ou à l'intérieur du matériau.

Le film opacifiant sera un film technique composé principalement de cristaux liquides (LCD). Les couches qui le composent rejettent la lumière de deux façons, soit par l'absorption de l'énergie solaire soit par la réflexion. Le film fera barrière à plus de 99 % des UV responsables des cancers de la peau et des carcinomes. Il diminuera entre 5 et 95 % la lumière visible et entrainera ainsi une réduction de chaleur importante. Il réduira considérablement la température des pièces d'une habitation, d'un bureau ou l'habitacle d'une voiture.

Notre choix se portera sur un film à technologie de réflexion de la lumière afin que la lumière pas encore absorbée par le dispositif énergétique soit de nouveau réfléchie sur les cellules dudit dispositif afin d'atteindre une conversion électrique optimum.

Ainsi, le film opacifiant sera un moyen supplémentaire de protection de l'environnement en participant aux économies d'énergie. Il engendrera une réduction de la facture d'air conditionné en été et gardera la chaleur en hiver. Il évitera en plus la décoloration des matériaux ou objets à l'intérieur des véhicules ou des habitations ou des bâtiments ou des structures industriels ou commerciales.

Dans un mode de réalisation, le film opacifiant pourra être remplacé par une couche opacifiante directement intégrée dans le gel et constituée principalement de cristaux liquides à commutation électro-optique et technologie de réflexion. Dans leur état non excité, c'est-à-dire sans tension électrique appliquée, les molécules de cristaux liquides seront alignées de manière aléatoire. Cette configuration permettra à la lumière de traverser le matériau, le rendant transparent. Puis en appliquant une tension électrique, les molécules de cristaux liquides s'aligneront pour bloquer ou disperser la lumière. Cela créera un effet d'obscurcissement en rendant le matériau partiellement opaque ou opaque à plus de 90% et ce en fonction du niveau de tension appliquée; permettant ainsi un meilleur rendement de conversion photoélectriques (grâce à la réflexion de la lumière). Cette variabilité du taux d'opacité ou du niveau de tension électrique appliquée pourra être une fonctionnalité du dispositif énergétique qui en assurera le contrôle . Le retour à l'état de transparence se fera lorsque la tension électrique sera de nouveau supprimée, les molécules de cristaux liquides reviendront progressivement à leur configuration initiale, ce qui permettra à la lumière de traverser à nouveau le matériau et le rendre transparent.

Pour lutter contre les intempéries qui proviennent de l'extérieur, le film ou la couche opacifiant pourra représenter des protections esthétiques de bureaux à structures transparentes tout en conservant l'intimité de chacun par rapport à l'extérieur ou au sein d'espaces de travail partagés.

De même, les miroirs tels ceux des rétroviseurs intérieurs et extérieurs des véhicules électriques ou hybrides pourront automatiquement ou manuellement s'obscurcir, ce qui est un gage de sécurité.

La pose du dispositif dans la structure de la coque aluminium d'un rétroviseur permettra par commutation électrique de passer d'un état réfléchissant à transparent et de permettre ainsi au véhicule terrestre à moteur de récupérer de l'énergie.

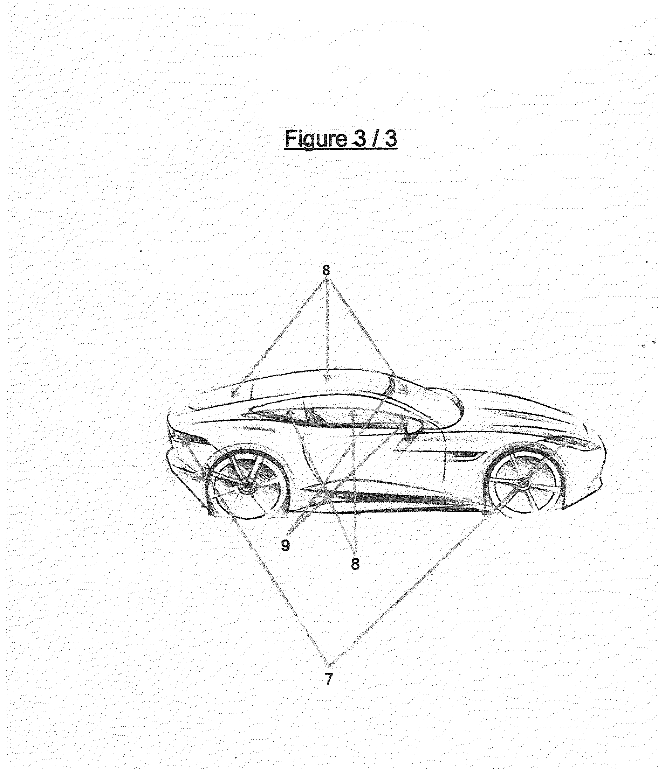

### Exemple de réalisation (Fig 3)

Un cas concret de réalisation peut être effectué sur un véhicule disposant d'au moins une batterie électrique rechargeable. Le dispositif énergétique est intégré dans les surfaces vitrées (Fig 3.8), dans les miroirs des rétroviseurs intérieurs et extérieurs (Fig 3.9) ainsi que dans les Plexiglas°, les verres et plastiques du véhicule (Fig 3.7)

### Numéros de référence employés sur les figures

1 Cellules thermoélectriques et/ou TPV
2 Couche transparente de cellules thermoélectriques et/ou TPV
3 Cellules photovoltaïques
4 Gel transparent hydroélectrique
5 Feuille de Plexiglas°, de verre, de miroir ou matériaux conducteurs ou semi-conducteurs ou transparents ou semi-transparents ou réfléchissants
6 Film opacifiant et autonome
7 Dispositif énergétique intégré dans les Plexiglas°, verres, plastiques d'un véhicule électrique
8 Dispositif énergétique intégré dans les surfaces vitrées d'un véhicule électrique
9 Dispositif énergétique intégré dans les miroirs des rétroviseurs intérieurs et extérieurs d'un véhicule électrique

## Revendications

1. Dispositif énergétique combiné en conversion photovoltaïque et thermoélectrique comportant une couche thermoélectrique et/ou thermophotovoltaïque (TPV) transparente et un gel hydroélectrique transparent contenant des cellules photovoltaïques et étant **caractérisé en ce que**
- Lesdites cellules thermoélectriques et/ou TPV sont disposées dans le gel par exemple sous forme filaire ou idéalement positionnées sur un film souple transparent, lui même posé en surface dudit gel de sorte les dites cellules soient en contact avec ledit gel
- Lesdites cellules photovoltaïques sont supportées par un fil transparent conducteur capable de transporter des charges électriques et/ou ioniques ou sont interconnectées entre elles par un fil conducteur transparent disposé systématiquement entre deux cellules successives, laissant une zone de transparence entre chaque cellule, de sorte que le dispositif photovoltaïque se présente sous forme filaire dans le gel, d'une épaisseur inférieure à 150 microns
- Lesdites cellules photovoltaïques disposées sur un substrat filaire transparent sont microscopiques ou semi-transparentes ou formées d'un empilement de couches minces, elles sont séparées et alignées entre elles de sorte que lesdites cellules soient invisibles à l'œil nu, et elles fonctionnent dans un gel hydroélectrique transparent
- Le dispositif énergétique est intégré à l'intérieur de matériaux transparents/semi-transparents ou posé entre deux couches
- Le dispositif énergétique comporte au moins une électrode fichée dans ledit gel hydroélectrique transparent, qui permet de récupérer puis de ré-injecter l'électricité produite par l'ensemble du fait de la lumière et de la chaleur dans une batterie rechargeable ou tout autre appareil ou dispositif électrique ou bien directement alimenter une résistance dans le cadre d'un dispositif calorifique.

2. Dispositif énergétique selon la revendication 1 **caractérisé en ce que** lesdits matériaux transparents/semi-transparents sont choisis parmi les vitrages, les miroirs, le Plexiglas°, les plastiques ou les composites.

3. Dispositif énergétique selon la revendication 1 **caractérisé en ce que** ledit gel hydroélectrique transparent a des propriétés diélectriques tout en permettant le transport de l'électricité et de la chaleur, il est anti-reflet, thermocollant, a de grande capacité de solidification, n'est pas électroluminescent, n'est pas visqueux.

4. Dispositif énergétique selon la revendication 3 **caractérisé en ce qu'**il est adapté pour se fixer dans ledit film souple transparent posé ou collé ou intégré sur tous matériaux notamment non-conducteurs ou non-transparents.

5. Dispositif énergétique selon la revendication 1 **caractérisé en ce que** lesdites cellules thermoélectriques et/ouTPV sont semi-transparentes et/ou séparées entre elles par des zones de transparence, de sorte que les dites cellules ne sont pas visibles à l'oeil nu.

6. Dispositif énergétique selon la revendication 5 **caractérisé en ce que** lesdites cellules thermoélectriques et/ou TPV filtrent elles-mêmes les longueurs d'onde requises, de sorte que le rayonnement qui n'est pas absorbé passe à travers les cellules vers un autre émetteur.

7. Dispositif énergétique selon la revendication 6 **caractérisé en ce que** lesdites cellules thermoélectriques et/ou TPV sont positionnées de sorte qu'elles ne diminuent pas davantage le passage de la lumière au travers des cellules photovoltaïques présentes dans ledit gel.

8. Dispositif énergétique selon l'une des revendications précédentes **caractérisé en ce que** lesdites cellules thermoélectriques présentent une face chaude et une face froide, en contact respectivement avec un radiateur semi-transparent chaud et un radiateur semi-transparent froid composés chacun de bandes thermiques, parallèles et espacées par des bandes de transparence, de sorte que les radiateurs polarisent d'une manière rectiligne une partie du spectre de la lumière qui les traverse et que la lumière polarisée qui a traversé l'un des radiateurs traverse ensuite l'autre radiateur sans perte d'intensité. Ces dites cellules thermoélectriques traversées par un courant généré par les cellules photovoltaïques dudit gel et/ou les cellules TPV ou par un courant électrique généré par une source de courant extérieure échauffent et/ou refroidissent chacune de leurs dites faces puis échauffent et refroidissent leurs radiateurs correspondants de manière à échauffer et/ou refroidir chacune des faces de ladite surface thermoélectrique. Une application de ce mode de réalisation est le dégivrage des vitres, miroirs et rétroviseurs d'un véhicule.

9. Dispositif énergétique selon l'une des revendications précédentes **caractérisé en ce qu'**il comporte en outre un système opacifiant à cristaux liquides (LCD) à technologie de réflexion, de sorte que la lumière incidente non absorbée soit de nouveau réfléchie sur lesdites cellules dudit dispositif, ledit système opacifiant est soit un film opacifiant étant fixé sur ou à l'intérieur du matériau, ledit film étant autonome, en outre, un film s'opacifiant manuellement ou instantanément, soit une couche opacifiante ayant les mêmes propriétés que ledit film, directement intégrée dans ledit gel, et contenant principalement des cristaux liquides à commutation électro-optique et technologie de réflexion de la lumière.

10. Dispositif énergétique selon au moins l'une des revendications précédentes **caractérisé en ce qu'**il est adapté pour se fixer ou s'insérer sur une surface vitrée, un rétroviseur ou un miroir, un Plexiglas° ou un plastique ou un élément composite, ou sur des matériaux non-conducteurs ou non-transparents.
